# EUROPEAN PATENT APPLICATION

(11) **EP 4 832 319 A1**
(43) Date of publication of application: **28.10.2026**
(21) Application number: 24906889.1
(22) Date of filing: 15.10.2024
(51) Int. Cl.: H02K 41/03

(54) **DRIVING APPARATUS, POSITIONING APPARATUS, PROCESSING APPARATUS, AND DEVICE MANUFACTURING METHOD**

(30) Priority: 21.12.2023 JP 2023215850
(71) Applicant: Sumitomo Heavy Industries, Ltd., Tokyo 141-6025 (JP)
(72) Inventor: YOSHIDA Tatsuya, Yokosuka-shi Kanagawa 237-8555 (JP); MUROI Naoto, Yokosuka-shi Kanagawa 237-8555 (JP)
(74) Representative: Louis Pöhlau Lohrentz
(86) International application number: PCT/JP2024/036638
(87) International publication number: WO 2025/134501

(57) **Abstract**

A stage device 1 includes a first drive shaft 100 that drives a stage 2 in an X-axis direction by magnetism, a second drive shaft 200 that drives the stage 2 and the first drive shaft 100 integrally in a Y-axis direction intersecting the X-axis direction by magnetism and that supports the first drive shaft 100 from below in a Z-axis direction intersecting the X-axis direction and the Y-axis direction, a first gas levitation portion 10 that levitates an X slider 21 from an X guide 110 by gas, and a second gas levitation portion 20 that levitates a Y slider 150 from a Y guide 210 by gas.

## Description

### Technical Field

The present disclosure relates to a driving device and the like.

### Background Art

PTL 1 discloses a driving device or an actuator used in a vacuum environment, which includes a slider driven along a predetermined movement direction by gas pressure in an air servo chamber, and a guide extending in the movement direction to guide the slider. An air bearing formed by compressed air supplied between an outer periphery of the slider and an inner periphery of the guide through an air pad allows the slider to levitate from the guide and smoothly move.

### Citation List

### Patent Literature

[PTL 1] Japanese Patent No. 6893170

### Summary of Invention

### Technical Problem

In a gas pressure actuator as in PTL 1, there is a problem in that it is difficult to increase responsiveness or quick responsiveness in a case of driving a slider due to a physical constraint based on a principle of converting a gas pressure in an air servo chamber into a thrust force of the slider.

The present disclosure has been made in view of such circumstances, and an object of the present disclosure is to provide a driving device or the like capable of achieving both smoothness and responsiveness in a case of driving a driven body.

### Solution to Problem

In order to solve the above-described problem, a driving device according to an aspect of the present invention includes a first drive shaft that drives a driven body in a first direction by magnetism, a second drive shaft that drives the driven body and the first drive shaft integrally in a second direction intersecting the first direction by magnetism and that supports the first drive shaft from below in a third direction intersecting the first direction and the second direction, a first gas levitation portion that levitates the driven body from the first drive shaft by gas, and a second gas levitation portion that levitates the first drive shaft from the second drive shaft by gas.

According to the present aspect, high responsiveness during driving can be achieved by the first drive shaft and the second drive shaft that drive the driven body and the first drive shaft by magnetism, and high smoothness during driving can be achieved by the first gas levitation portion and the second gas levitation portion that levitate the driven body and the first drive shaft by gas.

Another aspect of the present disclosure is a positioning device. This device positions the driven body by the above-described driving device.

Still another aspect of the present disclosure is a processing device. The device performs predetermined processing on the driven body positioned by the positioning device.

Yet another aspect of the present disclosure is a device manufacturing method. In the method, a device is manufactured through processing performed by the processing device.

Any combination of the above components and representations thereof converted into a method, a device, a system, a recording medium, a computer program, and the like are also included in the present disclosure.

### Advantageous Effects of Invention

According to the present disclosure, both smoothness and responsiveness during driving of the driven body can be achieved.

### Brief Description of Drawings

FIG. 1 is a perspective view schematically illustrating a stage device.
FIG. 2 is a cross-sectional view taken along line A-A of FIG. 1.
FIG. 3 is a cross-sectional view taken along line B-B of FIG. 1.
FIG. 4 is a partial enlarged view of a first magnet portion.
FIG. 5 is a cross-sectional view schematically illustrating a gas levitation portion.

### Description of Embodiments

Hereinafter, a form for embodying the present disclosure (hereinafter, also referred to as an embodiment) will be described in detail with reference to the accompanying drawings. In the description and/or the drawings, the same reference signs are assigned to the same or equivalent components, members, processes, and the like, and repeated descriptions thereof are omitted. The scale and shape of each unit illustrated in the drawings are set for convenience to simplify the description, and are not to be construed as limiting unless otherwise specifically stated. The embodiment is illustrative and does not limit the scope of the present disclosure in any way. All the features and combinations thereof presented in the embodiments are not necessarily essential to the present disclosure. For convenience, the embodiment is presented by decomposing the embodiment into components for each function and/or for each function group implementing the embodiment. However, one component in the embodiment may actually be implemented by a combination of a plurality of separate components, and a plurality of components in the embodiment may actually be implemented by one component as an integral body. In addition, a plurality of embodiments or modifications may be disclosed in parallel. However, any components of each embodiment and/or each modification may be combined in any manner as long as each other's functions are not impaired.

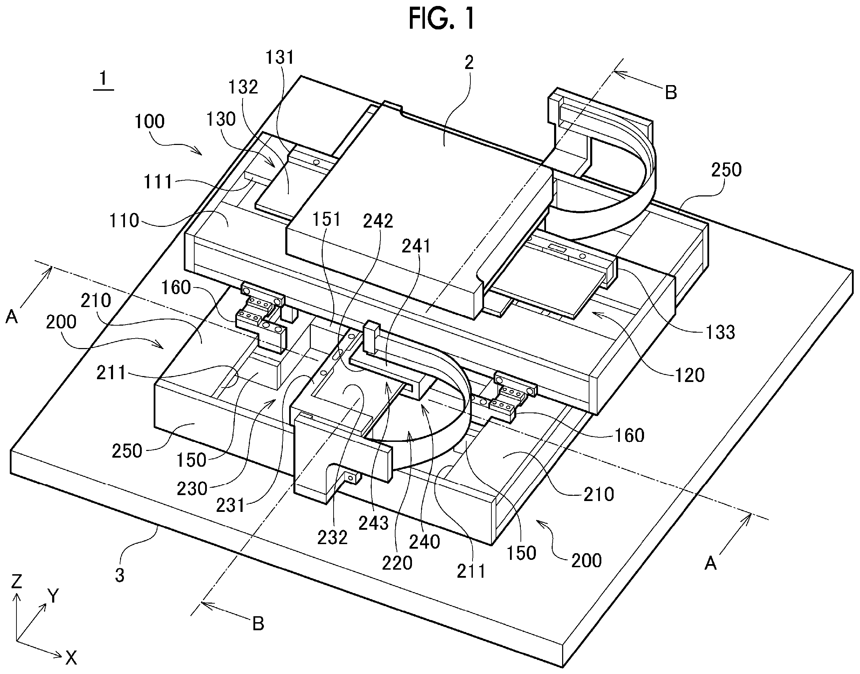

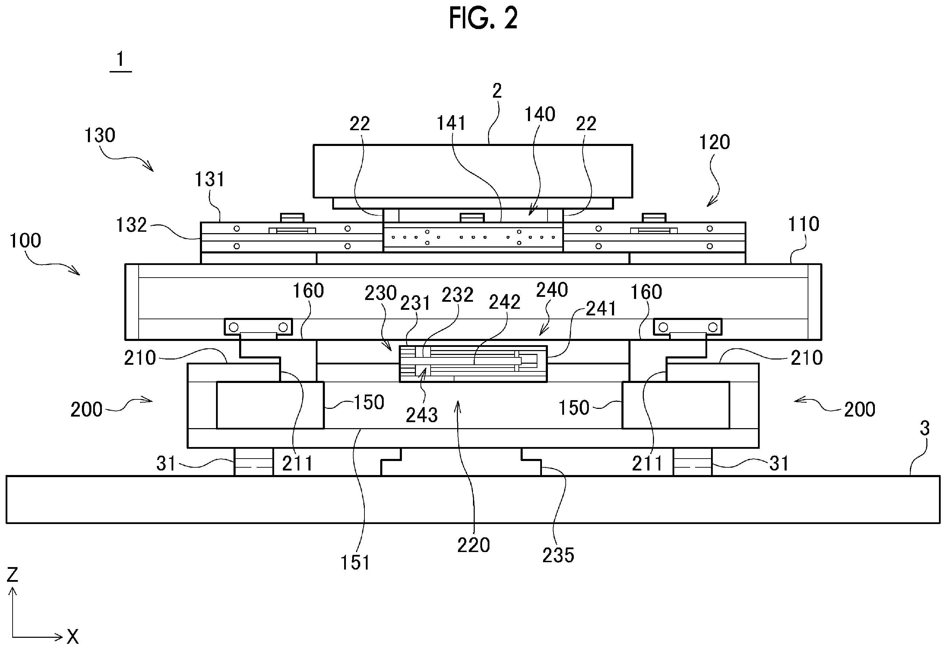

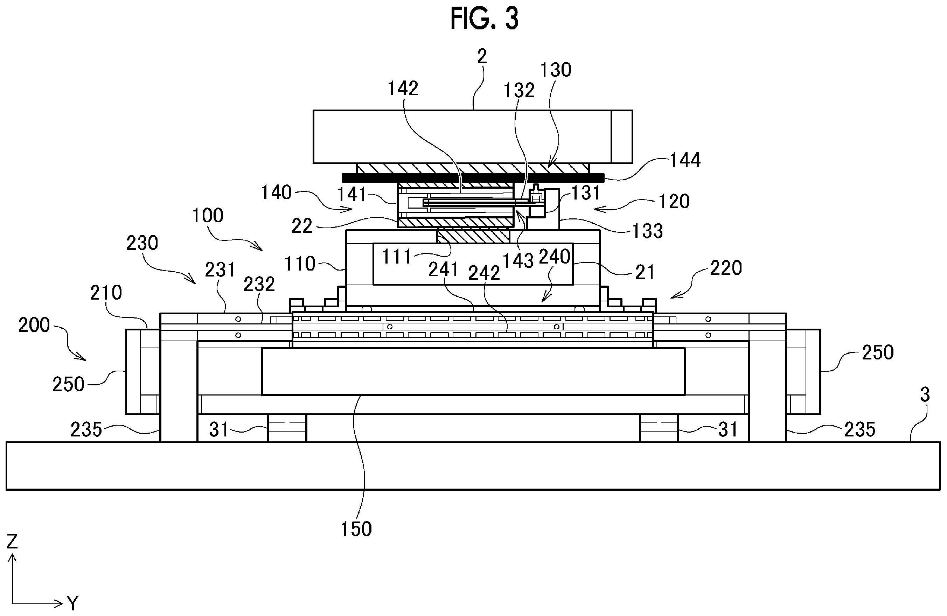

FIG. 1 is a perspective view schematically illustrating a stage device 1 as a driving device or a positioning device according to an embodiment of the present disclosure. In the present embodiment, for convenience, a three-dimensional coordinate system or an XYZ coordinate system formed by an X-axis, a Y-axis, and a Z-axis that are orthogonal to each other is set. An X-axis direction is a first direction in which a first drive shaft 100, which will be described later, drives a stage 2 or a table as a driven body. A Y-axis direction is a second direction in which a second drive shaft 200, which will be described later, integrally drives the stage 2 and the first drive shaft 100. A Z-axis direction is a third direction as a normal direction to a drive plane or an XY plane formed by the X-axis and the Y-axis. The XY plane is preferably a horizontal plane, and the Z-axis direction in this case is a vertical direction. The X-axis, the Y-axis, and the Z-axis do not need to be orthogonal to each other, and may at least intersect with each other. In other words, the X-axis direction, the Y-axis direction, and the Z-axis direction may be different from each other. FIG. 2 is a cross-sectional view (ZX plane view) taken along line A-A of FIG. 1. FIG. 3 is a cross-sectional view (YZ plane view) taken along line B-B of FIG. 1.

The stage device 1 includes the first drive shaft 100 that drives the stage 2 in the X-axis direction by magnetism, and the second drive shaft 200 that integrally drives the stage 2 and the first drive shaft 100 in the Y-axis direction by magnetism. In the example of the present embodiment, a pair (that is, two) of substantially the same second drive shafts 200 are provided to overlap both end portions of the first drive shaft 100 extending in the X-axis direction when viewed in the Z-axis direction or when viewed from above. Hereinafter, unless otherwise specified, the two second drive shafts 200 will be collectively described without being distinguished.

The second drive shaft 200 supports the first drive shaft 100 from below in the Z-axis direction. That is, the upper first drive shaft 100 and the lower second drive shaft 200 form a stack structure stacked in the Z-axis direction, which is a vertical direction. Specifically, as illustrated in FIG. 2, a bottom portion of an X guide 110 (to be described later), which is a main body of the first drive shaft 100, is connected to a top portion of a Y slider 150 (to be described later) accommodated inside a Y guide 210 (to be described later), which is a main body of the second drive shaft 200, via a support portion 160. The support portion 160 prevents an integral structure including the X guide 110 and the Y slider 150 from being shifted in the X-axis direction by being supported by an end surface of an opening 211 in the Y guide 210. Further, a load of the X guide 110 in the Z-axis direction may be received by balls (no reference numeral) or the like provided between a bottom surface of the X guide 110 and a top surface of a second linear motor 220, as illustrated in FIG. 3.

One first drive shaft 100 and two second drive shafts 200 form a substantially H shape when viewed in the Z-axis direction or when viewed from above. As illustrated in FIGS. 2 and 3, the second drive shaft 200 is fixedly installed via a plurality of fixed legs 31 on a surface of a surface plate or a base 3, the surface being in an XY plane or a horizontal plane. As illustrated in FIG. 2, the two second drive shafts 200 are disposed substantially parallel to each other at different positions in the X-axis direction spaced apart by a distance substantially the same as a length of the first drive shaft 100 in the X-axis direction. As illustrated in FIG. 1, connecting plates 250 for connecting these two second drive shafts 200 in the X-axis direction are respectively provided on a front surface (-Y side surface) and a rear surface (+Y side surface). The two second drive shafts 200 and the two connecting plates 250 form a substantially rectangular shape or a substantially square shape as viewed in the Z-axis direction or as viewed from above. As illustrated in FIG. 2, the one first drive shaft 100 is in a non-contact state spaced apart from the surface of a base 3 (and the two second drive shafts 200) in the Z-axis direction so as to be movable in the Y-axis direction above the base 3 (and the two second drive shafts 200) through the two second drive shafts 200.

The stage 2 constituting the driven body constitutes a placement portion on a surface of which any object (not illustrated) is placed. Here, the "surface" in the present embodiment represents a surface on the +Z side (an upper surface in FIG. 1), and the "rear surface" in the present embodiment represents a surface on the -Z side (a lower surface in FIG. 1). Any workpiece such as a semiconductor wafer may be placed on the surface of the stage 2. In this case, the stage device 1 constitutes a positioning device that positions a workpiece placed on the stage 2 as the driven body, and further constitutes a part of a processing device that performs any processing on the workpiece positioned by the positioning device. Examples of the processing device include a semiconductor manufacturing device such as an exposure device, an ion implanter, a heat treatment device, an ashing device, a sputtering device, a dicing device, an inspection device, and a cleaning device, and a flat panel display (FPD) manufacturing device.

The first drive shaft 100 that drives the stage 2 as the driven body in the X-axis direction includes an X guide 110 as a first guide extending in the X-axis direction. The X guide 110 constitutes a main body of the first drive shaft 100. In the example of the present embodiment, the X guide 110 is formed in a hollow box shape or a rectangular parallelepiped shape having an opening 111 having rectangular shape and extending over substantially the entire length in the X-axis direction on the surface.

As illustrated in FIG. 3, an X slider 21 as a first slider movable or slidable in the X-axis direction while being guided by an inner peripheral surface of the X guide 110 is provided in, for example, a space having a substantially rectangular parallelepiped shape inside the X guide 110. In the example of FIG. 3, a YZ cross-section having a rectangular shape formed by the inner peripheral surface of the X guide 110 and a YZ cross-section having a rectangular shape formed by an outer peripheral surface of the X slider 21 are substantially equal to each other (strictly speaking, the latter is slightly smaller). As will be described later, since a levitation gas such as compressed air is supplied between an inner peripheral surface of the X guide 110 constituting the first drive shaft 100 and an outer peripheral surface of the X slider 21 constituting the driven body, the X slider 21 can be levitated from the X guide 110 and can smoothly move in a substantially non-contact manner.

A surface (surface on the +Z side) of the X slider 21 is connected to a rear surface (surface on the -Z side) of the stage 2 and integrally constitutes the driven body. Specifically, one or a plurality of connecting portions 22 having a columnar shape illustrated in FIG. 2 pass through the opening 111 illustrated in FIG. 3 in the Z-axis direction to connect the rear surface of the stage 2 and the surface of the X slider 21 (a first magnet portion 140 may be interposed as will be described later). The stage 2 and the X slider 21 as the driven body interconnected by the connecting portions 22, and the first magnet portion 140 fixed to the driven body as will be described later constitute a movable portion movable integrally in the X-axis direction.

As will be described later, when the X slider 21 is driven in the X-axis direction while being guided by the X guide 110 by the first magnet portion 140 (and a first coil portion 130), the stage 2 connected by the connecting portions 22 is also integrally driven in the X-axis direction. In this case, the connecting portions 22 also move in the X-axis direction, but since the connecting portions 22 pass through the opening 111 formed on the surface of the X guide 110 over substantially the entire length in the X-axis direction, the movement of the driven body (the stage 2 and the X slider 21) in the X-axis direction is not hindered.

In order to drive the driven body constituted by the stage 2 and the X slider 21 along the X-axis direction, a first linear motor 120 is configured between the driven body and the first drive shaft 100. In the present embodiment, one first linear motor 120 is provided on the rear surface side (-Z side) of the stage 2 as the driven body. As illustrated in FIG. 3, the first linear motor 120 is provided on the surface side (+Z side) of the X slider 21 movable integrally with the stage 2 (and the X guide 110 as a main body of the first drive shaft 100). In this manner, by providing the first linear motor 120 on the rear surface side of the stage 2, an adverse effect that the magnetism leaked from the first linear motor 120 may have on processing of a semiconductor wafer or the like on the stage 2 (for example, irradiation with an electron beam susceptible to the magnetism) can be reduced.

In general, a linear motor includes a coil portion constituted by a plurality of coils through which a current flows from the outside to generate a magnetic field, and a magnet portion constituted by a plurality of magnets that interact with the magnetic field generated by the coil portion. The first linear motor 120 according to the present embodiment also includes a first coil portion 130 as a coil portion and a first magnet portion 140 as a magnet portion. In order to constitute the first linear motor 120 that drives the X slider 21 (and the stage 2) as the driven body along the X-axis direction, one of the first coil portion 130 and the first magnet portion 140 may be provided on the X slider 21, and the other may be provided on the first drive shaft 100.

In the first linear motor 120, the first coil portion 130 is preferably provided on the first drive shaft 100, and the first magnet portion 140 is preferably provided on the X slider 21. As illustrated in FIG. 3, the first coil portion 130 is fixed on the surface of the X guide 110, which is a main body of the first drive shaft 100, by a fixture 133 having an inverted L-shaped cross-section. The first magnet portion 140 is fixed to the rear surface side of the stage 2 and the surface side of the X slider 21 via the connecting portions 22 that connect the stage 2 and the X slider 21. The first magnet portion 140 and the connecting portions 22 do not contact the surface of the X guide 110, and furthermore, the connecting portions 22 do not contact the inner peripheral surface in the opening 111 of the X guide 110. Therefore, the first magnet portion 140 and the connecting portions 22 are movable integrally with the X slider 21 in the X-axis direction in a substantially non-contact manner with the X guide 110.

As illustrated in FIGS. 2 and 3, the first linear motor 120 is provided between the upper stage 2 and the lower X slider 21. Since the first coil portion 130 constituting a fixation portion is disposed at an intermediate position in the Z-axis direction not in contact with the X slider 21 and the stage 2 constituting the movable portion, the movement of the movable portion in the X-axis direction is not hindered. Furthermore, since the first linear motor 120 (driving point) can be disposed at a position in the Z-axis direction close to the center of gravity of the entire movable portion constituted by the X slider 21 and the stage 2, the movable portion can be stably driven while suppressing undesirable pitching rotation or the like of the movable portion.

The first magnet portion 140 is driven integrally with the X slider 21 in the X-axis direction by a magnetic interaction with the first coil portion 130. Since the first magnet portion 140 moves in this manner, the first linear motor 120 is a so-called moving magnet type linear motor. In this case, since the first coil portion 130 that generates heat by a current flowing therethrough is isolated from the driven body constituted by the stage 2 and the X slider 21, heat transfer to the stage 2 and/or a workpiece such as a semiconductor wafer can be effectively suppressed. This is particularly preferable when the workpiece such as a semiconductor wafer is susceptible to an influence of heat. In addition, since the first coil portion 130 is stationary in the X-axis direction (moves in the Y-axis direction by the second drive shaft 200), a current can be easily supplied to the first coil portion 130.

In the moving magnet type first linear motor 120, the length of the first coil portion 130 in the X-axis direction is longer than the length of the first magnet portion 140 in the X-axis direction. For example, it is preferable that the length of the first coil portion 130 in the X-axis direction is a length that can cover the movable range of the X slider 21 in the X-axis direction. In addition, it is preferable that the length of the first magnet portion 140 in the X-axis direction is equal to or less than the length of the X slider 21 and/or the stage 2 in the X-axis direction. As will be described later, the first magnet portion 140 having a relatively short length is movable in the X-axis direction integrally with the X slider 21 and the stage 2 as the driven body within the installation range of the first coil portion 130 having a relatively long length.

On the other hand, when processing of a semiconductor wafer or the like on the stage 2 is less susceptible to an influence of heat, the first linear motor 120 may be configured as a so-called moving coil type. Specifically, the first coil portion 130 is provided integrally with the stage 2 and the X slider 21, and the first magnet portion 140 is provided on the first drive shaft 100 (for example, the X guide 110). In this case, since the first magnet portion 140 is stationary in the X-axis direction (moves in the Y-axis direction by the second drive shaft 200), there is an advantage that fluctuation in magnetism leaking outside the first linear motor 120 is small. This is particularly preferable when processing of a semiconductor wafer or the like on the stage 2 is susceptible to an influence of magnetism.

In the moving coil type first linear motor 120, a length of the first coil portion 130 in the X-axis direction is shorter than a length of the first magnet portion 140 in the X-axis direction. For example, it is preferable that the length of the first coil portion 130 in the X-axis direction is equal to or less than the length of the X slider 21 and/or the stage 2 in the X-axis direction. In addition, it is preferable that a length of the first magnet portion 140 in the X-axis direction is a length that can cover the movable range of the X slider 21 in the X-axis direction. The first coil portion 130 having a relatively short length is movable in the X-axis direction integrally with the X slider 21 and the stage 2 as the driven body within the installation range of the first magnet portion 140 having a relatively long length.

As illustrated in FIG. 1, the first coil portion 130 constituting the fixation portion preferably has a substantially rectangular shape having an X symmetry axis in the X-axis direction and a Y symmetry axis in the Y-axis direction substantially the same as those of the X guide 110 having a rectangular shape as viewed in the Z-axis direction or as viewed from above. In this case, the center of gravity or the center of the first coil portion 130 as viewed in the Z-axis direction substantially coincides with the center of gravity or the center of the X guide 110. Further, as illustrated in FIG. 3, the center or the middle of the first coil portion 130 in the Y-axis direction substantially coincides with the center or the middle of the stage 2 and/or the X slider 21 as the driven body in the Y-axis direction.

In this manner, the driven body can be stably driven in the X-axis direction while effectively suppressing undesirable rotation such as yawing (rotation around the Z-axis) by one first coil portion 130 or one first linear motor 120 symmetrically disposed with respect to the driven body.

As illustrated in FIG. 3, the first coil portion 130 includes a holder 131 that is fixedly attached to a fixture 133, and a coil 132 that is held by the holder 131. Although not illustrated in detail, the coil 132 is, for example, a general three-phase coil. Specifically, a U-phase coil, a V-phase coil, and a W-phase coil (not illustrated) are periodically disposed along the X-axis direction, which is a driving direction. Currents (for example, a U-phase current, a V-phase current, and a W-phase current) flowing through the coil 132 of each phase may be supplied via the holder 131. The coil 132 is provided so as to protrude from the holder 131 on the +Y side toward the -Y side. Such a coil 132 or a coil group is preferably formed in a flat plate shape having the Z-axis direction as a normal direction as a whole. The holder 131 is fixed to the surface of the X guide 110 via the above-described fixture 133.

The first magnet portion 140 includes a casing 141 having a substantially rectangular parallelepiped shape and magnets 142 arranged on an inner peripheral surface of the casing 141. The casing 141 is made of, for example, a magnetic shielding material or a soft magnetic material such as carbon steel or permalloy. An elongated opening 143 extending in the X-axis direction over substantially the entire length thereof is formed on a side surface of the casing 141 on the +Y side (a side surface of the casing 141 on the -Y side is closed by a magnetic shielding material or the like). The coil 132 having a flat plate shape provided so as to protrude toward the -Y side from the holder 131 of the first coil portion 130 is inserted into a space having a substantially rectangular parallelepiped shape inside the casing 141 formed by this opening 143. In addition, the magnets 142 such as permanent magnets whose magnetic poles are periodically changed are arranged along the X-axis direction on the inner peripheral surface of the casing 141 that is the top surface and/or the bottom surface of the space.

In this manner, in the space having a substantially rectangular parallelepiped shape inside the casing 141, the coil 132 or a coil group in the first coil portion 130 and the magnets 142 or a magnet group in the first magnet portion 140 face each other in the Z-axis direction. Then, the coil 132, functioning as an electromagnet when a three-phase alternating current or the like flows therethrough, magnetically interacts with the magnets 142, so that a thrust force for driving the magnets 142 as a movable portion in the X-axis direction is generated. The casing 141 having an inverted U-shape as viewed in the X-axis direction of FIG. 3 is driven in the X-axis direction along the coil 132 having a flat plate shape in a state of sandwiching the coil 132 having a flat plate shape from the left side (a state where the coil 132 is included in the space inside the casing 141). The X slider 21 as the driven body to which the casing 141 of the first magnet portion 140 is fixed is also driven integrally with the first magnet portion 140 in the X-axis direction while being guided by the X guide 110.

As described above, in the present embodiment, the coil 132 through which a current flows is provided so as to protrude from the holder 131 toward the -Y side, and the first magnet portion 140 or the magnets 142 that interact with the magnetic field generated by the coil 132 are provided so as to cover the coil 132 from the -Y side.

In the first linear motor 120 according to the present embodiment, since the casing 141 of the first magnet portion 140 is open on a side surface (opening 143) on the right side in FIG. 3 and on a front surface and a rear surface (not illustrated), there is a possibility that the magnetism from the magnets 142 and/or the coil 132 leaks. Since the magnetism leaked from the opening 143 or the like may have an adverse effect on processing of a semiconductor wafer or the like on the stage 2, a magnetic shielding portion for shielding magnetism from the stage 2 is provided in the present embodiment.

As illustrated in FIG. 3, the magnetic shielding portion may include, for example, a first magnetic shielding portion 144 having a flat plate shape (not illustrated in drawings other than FIG. 3) provided between the lower first linear motor 120 or the first coil portion 130 and the upper stage 2. The first magnetic shielding portion 144 shields the magnetism leaked from the first linear motor 120 from the stage 2. The first magnetic shielding portion 144 is made of, for example, a magnetic shielding material such as permalloy. The first magnetic shielding portion 144 preferably covers the entirety of the first linear motor 120 or the first coil portion 130 as viewed in the Z-axis direction or as viewed from above.

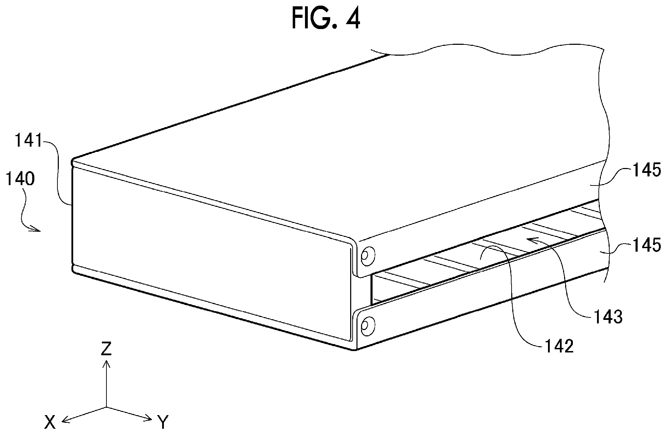

FIG. 4 is a partially enlarged view of the first magnet portion 140. The magnetic shielding portion may include a second magnetic shielding portion 145 that magnetically shields at least an edge portion (an upper edge portion and/or a lower edge portion in FIG. 4) of the opening 143 into which the coil 132 (not illustrated) is inserted. The second magnetic shielding portion 145 is made of, for example, a magnetic shielding material such as permalloy. The second magnetic shielding portion 145 may continuously cover the surface and/or the rear surface of the casing 141 from the edge portion of the opening 143.

A pair of second drive shafts 200 that integrally drive the stage 2 and the X slider 21 as the driven body and the first drive shaft 100 in the Y-axis direction include Y guides 210 as a pair of second guides extending in the Y-axis direction. The Y guide 210 constitutes a main body of the second drive shaft 200. In the example of the present embodiment, a pair of Y guides 210 are formed in a box shape or a rectangular parallelepiped shape together with the connecting plates 250 on the front surface and the rear surface described above. The pair of Y guides 210 provided at both end portions in the X-axis direction support a pair of Y sliders 150 to be described later in a substantially non-contact manner on three surfaces of the surface, the end surface (the outer side surface in the X-axis direction), and the bottom surface.

As illustrated in FIG. 2, a Y slider 150 as a second slider movable or slidable in the Y-axis direction while being guided by an inner peripheral surface of the Y guide 210 is provided in a space surrounded from three surfaces by the Y guide 210. In the example of FIG. 2, a ZX cross-sectional shape formed by the inner peripheral surface of the Y guide 210 and a ZX cross-sectional shape formed by an outer peripheral surface of the Y slider 150 are substantially equal to each other (strictly speaking, the latter is slightly smaller). As will be described later, since a levitation gas such as compressed air is supplied between the inner peripheral surface of the Y guide 210 constituting the second drive shaft 200 and the outer peripheral surface of the Y slider 150 constituting the drive target, the Y slider 150 can be levitated from the Y guide 210 and can smoothly move in a substantially non-contact manner. As illustrated in FIG. 1, the pair of Y sliders 150 provided at both end portions in the X-axis direction are interconnected by one or a plurality of connecting portions 151 extending in the X-axis direction, and are movable integrally in the Y-axis direction. Therefore, the pair of second drive shafts 200 that drive the pair of Y sliders 150 in the Y-axis direction function substantially as one second drive shaft 200.

In an X-axis direction region on an inner side of both the Y guides 210 provided at both the end portions in the X-axis direction, an opening 211 having a rectangular shape extending over substantially the entire length in the Y-axis direction is formed on the surface. As illustrated in FIG. 2, through this opening 211, the bottom portion of the X guide 110, which is a main body of the first drive shaft 100, is connected to the top portion of the Y slider 150 accommodated inside the Y guide 210, which is a main body of the second drive shaft 200, via the support portion 160. Therefore, the first drive shaft 100 and the stage 2 are movable integrally with the Y slider 150 in the Y-axis direction. Further, the second linear motor 220 to be described later that drives these drive targets in the Y-axis direction is also disposed in the opening 211.

As will be described later, when the Y slider 150 is driven in the Y-axis direction while being guided by the Y guide 210 by the second linear motor 220, the first drive shaft 100 or the stage 2 connected by the support portion 160 is also integrally driven in the Y-axis direction. In this case, the support portion 160 also moves in the Y-axis direction, but since the support portion 160 passes through the opening 211 formed on the surface between both the Y guides 210 over substantially the entire length in the Y-axis direction, the movement of the drive target (the first drive shaft 100 or the Y slider 150) in the Y-axis direction is not hindered.

The Y slider 150 connected on the lower side of the X guide 110 via the support portion 160 may be interpreted as a part of the first drive shaft 100. When the pair of second drive shafts 200 drive the pair of Y sliders 150 in the Y-axis direction, the entire first drive shaft 100 integrally constituted with the Y sliders 150, and the stage 2 and the X slider 21 as the driven body are also integrally driven in the Y-axis direction. In this manner, a drive target of the second drive shaft 200 includes the entire first drive shaft 100 having the Y sliders 150 as a part thereof, and the driven body constituted by the stage 2 and the X slider 21. That is, the stage 2 as the driven body is movable integrally with the Y slider 150 in the Y-axis direction while being guided by the Y guide 210.

In order to drive the drive target including the stage 2 and the Y slider 150 along the Y-axis direction, a second linear motor 220 is configured between the drive target and the second drive shaft 200. In the present embodiment, one second linear motor 220 extending in the Y-axis direction substantially in parallel with each Y guide 210 is provided at an intermediate position in the X-axis direction (for example, a midpoint) of the pair of Y guides 210. As illustrated in FIG. 2, the second linear motor 220 is provided on the surface side (+Z side) of the Y slider 150 movable integrally with the first drive shaft 100 and the stage 2 (and the Y guide 210 as a main body of the second drive shaft 200). In this manner, by providing the second linear motor 220 on the rear surface side of the stage 2, an adverse effect that the magnetism leaked from the second linear motor 220 may have on processing of a semiconductor wafer or the like (for example, irradiation with an electron beam susceptible to magnetism) on the stage 2 can be reduced.

The second linear motor 220 includes a second coil portion 230 as a coil portion and a second magnet portion 240 as a magnet portion. In order to constitute the second linear motor 220 that drives the Y slider 150 as the drive target along the Y-axis direction, one of the second coil portion 230 and the second magnet portion 240 may be provided on the Y slider 150, and the other may be provided on the second drive shaft 200.

In the second linear motor 220, it is preferable that the second coil portion 230 is provided adjacent to the second drive shaft 200 and the second magnet portion 240 is provided on the Y slider 150.

As illustrated in FIG. 3, the second coil portion 230 may be fixedly installed on the base 3 on which the second drive shaft 200 is installed via installation tables 235 provided at both end portions in the Y-axis direction. Since the base 3 and the second drive shaft 200 are fixed to each other, even if the second coil portion 230 is provided on either of the base 3 and the second drive shaft 200, the second coil portion 230 should be interpreted as being substantially provided on the second drive shaft 200. The second coil portion 230 (particularly, a coil 232 to be described later) is not in contact with the X guide 110 on the upper side or the Y guide 210 (and the Y slider 150) on the lower side and the lateral sides, and the second magnet portion 240 (particularly, a casing 241 to be described later) is movable in the Y-axis direction in a gap therebetween. In this manner, the second coil portion 230 is provided at a position spaced apart from the Y guide 210 as a main body of the second drive shaft 200 in the X-axis direction.

As illustrated in FIG. 2, the second magnet portion 240 may be fixedly attached to the connecting portion 151 connecting the pair of Y sliders 150. Further, the second magnet portion 240 may be fixedly attached to the rear surface of the X guide 110. Since the connecting portion 151, the X guide 110, the Y slider 150, and the like are fixed to each other, even if the second magnet portion 240 is provided on any of the connecting portion 151, the X guide 110, the Y slider 150, and the like, the second magnet portion 240 should be interpreted as being substantially provided on the Y slider 150.

As illustrated in FIGS. 2 and 3, the second linear motor 220 is provided between the upper X guide 110 and the lower Y slider 150. Since the second coil portion 230 constituting the fixation portion is disposed at an intermediate position in the Z-axis direction not in contact with the Y slider 150 and the first drive shaft 100 constituting the movable portion, the movement of the movable portion in the Y-axis direction is not hindered. Further, since the second linear motor 220 (a driving point) can be disposed at a position in the Z-axis direction close to the center of gravity of the entire movable portion constituted by the Y slider 150 and the first drive shaft 100, the movable portion can be stably driven while suppressing undesirable pitching rotation or the like.

As illustrated in FIG. 1, the second coil portion 230 constituting the fixation portion preferably has a substantially rectangular shape having an X symmetry axis in the X-axis direction and a Y symmetry axis in the Y-axis direction substantially the same as those of a rectangular region formed by the pair of Y guides 210 and a pair of connecting plates 250 as viewed in the Z-axis direction or as viewed from above. In this case, the center of gravity or the center of the second coil portion 230 as viewed in the Z-axis direction substantially coincides with the center of gravity or the center of the rectangular region. Further, as illustrated in FIG. 2, the center or the middle of the second coil portion 230 in the X-axis direction substantially coincides with the center or the middle of the X guide 110 and/or the pair of Y sliders 150 as the drive target in the X-axis direction.

In this manner, by one second coil portion 230 or the second linear motor 220 disposed symmetrically with respect to the drive target, the drive target can be stably driven in the Y-axis direction while effectively suppressing undesirable rotation such as yawing (rotation around the Z-axis).

As illustrated in FIG. 3, the second coil portion 230 includes a holder 231 that is installed on the base 3 via the installation tables 235, and the coil 232 that is held by the holder 231. Although detailed illustration is omitted, the coil 232 is, for example, a general three-phase coil. Specifically, a U-phase coil, a V-phase coil, and a W-phase coil (not illustrated) are periodically disposed along the Y-axis direction, which is a driving direction. Currents (for example, a U-phase current, a V-phase current, and a W-phase current) flowing through the coil 232 of each phase may be supplied via the holder 231. As illustrated in FIG. 2, the coil 232 is provided so as to protrude toward the +X side from the holder 231 on the -X side. Such a coil 232 or a coil group is preferably formed in a flat plate shape having the Z-axis direction as a normal direction as a whole. Further, as illustrated in FIG. 1, the entirety of the second coil portion 230 and/or the coil 232 extends along the Y-axis direction substantially in parallel with the pair of Y guides 210.

As illustrated in FIG. 2, the second magnet portion 240 includes the casing 241 having a substantially rectangular parallelepiped shape, and magnets 242 arranged on an inner peripheral surface of the casing 241. The casing 241 is fixedly attached to the surface of the connecting portion 151 of the Y slider 150 as the drive target. Therefore, the second magnet portion 240 is movable integrally with the Y slider 150 in the Y-axis direction.

The casing 241 is made of, for example, a magnetic shielding material or a soft magnetic material such as carbon steel or permalloy. An elongated opening 243 extending in the Y-axis direction over substantially the entire length thereof is formed on a side surface of the casing 241 on the -X side (a side surface of the casing 241 on the +X side is closed by a magnetic shielding material or the like). The coil 232 having a flat plate shape provided so as to protrude toward the +X side from the holder 231 of the second coil portion 230 is inserted into a space having a substantially rectangular parallelepiped shape inside the casing 241 formed by this opening 243. Further, the magnets 142 such as permanent magnets whose magnetic poles are periodically changed are arranged along the Y-axis direction on the inner peripheral surface of the casing 241 that is the top surface and/or the bottom surface of the space (see FIG. 3).

In this manner, in the space having a substantially rectangular parallelepiped shape inside the casing 241, the coil 232 or a coil group in the second coil portion 230 and the magnet 242 or a magnet group in the second magnet portion 240 face each other in the Z-axis direction. Then, the coil 232, functioning as an electromagnet when a three-phase alternating current or the like flows therethrough, magnetically interacts with the magnets 242, so that a thrust force for driving the magnets 242 as a movable portion in the Y-axis direction is generated. The casing 241 having a U-shape as viewed in the Y-axis direction of FIG. 2 is driven in the Y-axis direction along the coil 232 having a flat plate shape in a state of sandwiching the coil 232 having a flat plate shape from the right side (a state where the coil 232 is included in the space inside the casing 241). The Y slider 150 as the drive target to which the casing 241 of the second magnet portion 240 is fixed is also integrally driven in the Y-axis direction with the second magnet portion 240 while being guided by the Y guide 210.

As described above, in the present embodiment, the coil 232 through which a current flows is provided so as to protrude from the holder 231 toward the +X side, and the second magnet portion 240 or the magnets 242 that interact with the magnetic field generated by the coil 232 are provided so as to cover the coil 232 from the +X side.

The second linear motor 220 as described above, in which the second magnet portion 240 moves, is a so-called moving magnet type linear motor. In this case, since the second coil portion 230 generating heat due to a supplied current is isolated from the drive target integral with the stage 2 or the Y slider 150 (further, in the example of the present embodiment, the second coil portion 230 is also thermally isolated from the second drive shaft 200 via the installation tables 235 and the base 3), heat transfer to the stage 2 and/or a workpiece such as a semiconductor wafer can be effectively suppressed. This is particularly preferable when the workpiece such as a semiconductor wafer is susceptible to an influence of heat. In addition, since the second coil portion 230 is stationary, a current can be easily supplied to the second coil portion 230.

In such a moving magnet type second linear motor 220, the length of the second coil portion 230 in the Y-axis direction is longer than the length of the second magnet portion 240 in the Y-axis direction. For example, it is preferable that the length of the second coil portion 230 in the Y-axis direction is a length that can cover the movable range of the Y slider 150 in the Y-axis direction. In addition, it is preferable that the length of the second magnet portion 240 in the Y-axis direction is equal to or shorter than the length of the Y slider 150 and/or the stage 2 in the Y-axis direction. The second magnet portion 240 having a relatively short length is movable integrally with the Y slider 150 in the Y-axis direction as the drive target within an installation range of the second coil portion 230 having a relatively long length.

On the other hand, the second linear motor 220 may be configured as a moving coil type. Specifically, the second coil portion 230 is provided on the Y slider 150, and the second magnet portion 240 is provided on the second drive shaft 200 (for example, the base 3) (not illustrated). In this case, since the second magnet portion 240 is stationary, there is an advantage that fluctuation in magnetism leaking outside the second linear motor 220 is small. This is particularly preferable when processing of a semiconductor wafer or the like on the stage 2 is susceptible to an influence of magnetism.

In such a moving coil type second linear motor 220, the length of the second coil portion 230 in the Y-axis direction is shorter than the length of the second magnet portion 240 in the Y-axis direction. For example, it is preferable that the length of the second coil portion 230 in the Y-axis direction is equal to or shorter than the length of the Y slider 150 and/or the stage 2 in the Y-axis direction. In addition, it is preferable that the length of the second magnet portion 240 in the Y-axis direction is a length that can cover the movable range of the Y slider 150 in the Y-axis direction. The second coil portion 230 having a relatively short length is movable integrally with the Y slider 150 in the Y-axis direction as the drive target within the installation range of the second magnet portion 240 having a relatively long length.

Next, a gas levitation portion for smoothing driving in the X-axis direction by the first drive shaft 100 and driving in the Y-axis direction by the second drive shaft 200 will be described.

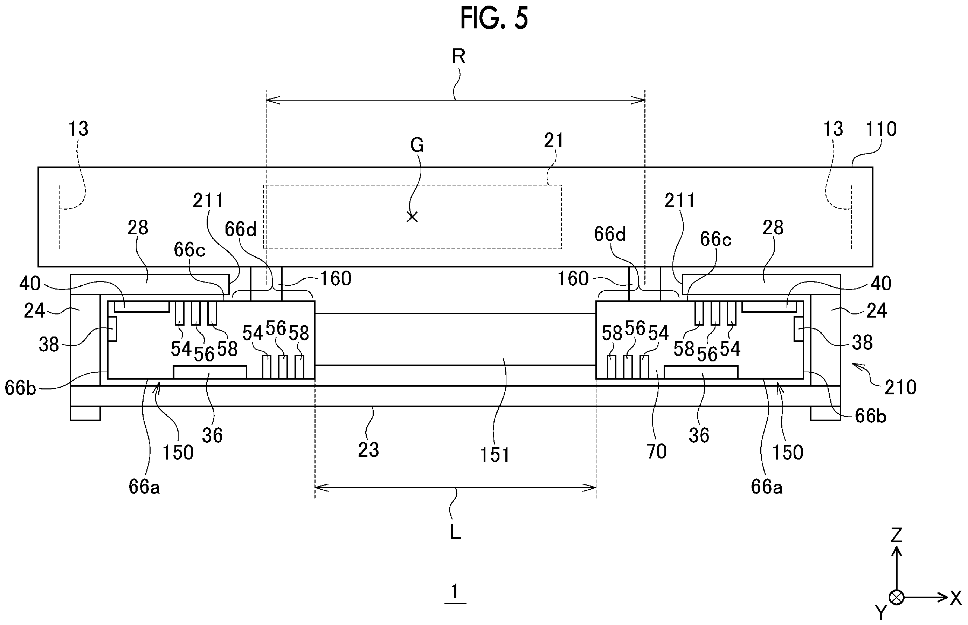

FIG. 5 is a cross-sectional view of the stage device 1 taken along a ZX plane including the connecting portion 151 of the Y slider 150. In this figure, the stage 2, the first linear motor 120, the second linear motor 220, and the like are not illustrated.

The Y guide 210 is a member having a box shape in which the center of the upper surface in the X-axis direction is opened. The Y guide 210 includes a bottom portion 23 on the -Z side, side walls 24 on the -X side and the +X side, and an upper portion 28 on the +Z side.

The bottom portion 23 is a member having a rectangular plate shape as viewed in the Z-axis direction or as viewed from above. The side walls 24 are walls elongated in the Y-axis direction provided upright toward the +Z side from both end portions (a left end portion and a right end portion in FIG. 5) of the bottom portion 23 in the X-axis direction. The left and right side walls 24 face each other in the X-axis direction.

The upper portion 28 is a plate member elongated in the Y-axis direction as viewed in the Z-axis direction or as viewed from above. The upper portion 28 is provided so as to extend toward the +X side from the upper end portion of the side wall 24 on the left side in FIG. 5, and is provided so as to extend toward the -X side from the upper end portion of the side wall 24 on the right side in FIG. 5. The right end of the upper portion 28 on the left side and the left end of the upper portion 28 on the right side constitute the opening 211 described above.

Each Y slider 150 having a substantially rectangular parallelepiped shape has a substantially rectangular ZX cross-section. In the Y slider 150 on the left side in FIG. 5, the entire outer side surface 66b (a side surface on the left side in FIG. 5) faces the side wall 24, the outer portion 66c on the surface (a portion excluding the inner portion 66d where the support portion 160 is provided) faces the upper portion 28, and the entire rear surface 66a faces the bottom portion 23. In the Y slider 150 on the right side in FIG. 5, the entire outer side surface 66b (a side surface on the right side in FIG. 5) faces the side wall 24, the outer portion 66c on the surface (a portion excluding the inner portion 66d where the support portion 160 is provided) faces the upper portion 28, and the entire rear surface 66a faces the bottom portion 23.

Air pads 36, 38, and 40 as static pressure bearings are formed between the inner peripheral surface of the Y guide 210 and the outer peripheral surface of the Y slider 150 such that the Y slider 150 can smoothly move in the Y-axis direction along the Y guide 210. Specifically, a rear surface air pad 36 is provided on the rear surface 66a of the Y slider 150 facing the bottom portion 23, a side surface air pad 38 is provided on the outer side surface 66b facing the side wall 24, and a surface air pad 40 is provided on the surface 66c facing the upper portion 28. The air pads 36, 38, and 40 are formed by constantly supplying a levitation gas (a second levitation gas) such as compressed air supplied from an air supply system (not illustrated) between the inner peripheral surface of the Y guide 210 and the outer peripheral surface of the Y slider 150.

The Y slider 150 levitated from the Y guide 210 by the air pads 36, 38, and 40 can smoothly move in a substantially non-contact manner with the Y guide 210. In this manner, the air pads 36, 38, and 40 constitute a second gas levitation portion that levitates the Y slider 150, which is a part of the first drive shaft 100, from the Y guide 210, which is a main body of the second drive shaft 200, by gas. The air pads 36, 38, and 40 may be provided on the inner peripheral surface of the Y guide 210 facing the Y slider 150 instead of the outer peripheral surface of the Y slider 150.

Exhaust grooves 54, 56, and 58 for differential exhaust are formed on the outer peripheral surface of the Y slider 150 so as to surround the air pads 36, 38, and 40. The exhaust grooves 54, 56, and 58 are provided such that a pressure sequentially decreases, that is, a degree of vacuum sequentially increases from the outer side toward the inner side or the center. For example, the exhaust groove 54 is set to an atmospheric pressure, the exhaust groove 56 is set to a low vacuum, and the exhaust groove 58 is set to a medium vacuum. The exhaust grooves 54, 56, and 58 having different pressures or degrees of vacuum in this manner are implemented by a plurality of exhaust pipes (not illustrated) provided inside the Y guide 210, which is a main body of the second drive shaft 200. Specifically, the exhaust groove 54 is set to atmospheric pressure by opening an exhaust pipe that communicates with the atmosphere or air at atmospheric pressure at a position facing the exhaust groove 54, the exhaust groove 56 is set to low vacuum by opening an exhaust pipe connected to a low vacuum pump (not illustrated) or the like at a position facing the exhaust groove 56, and the exhaust groove 58 is set to medium vacuum by opening an exhaust pipe connected to a medium vacuum pump (not illustrated) or the like at a position facing the exhaust groove 58.

By the plurality of exhaust grooves 54, 56, and 58 as described above, the levitation gas in the air pads 36, 38, and 40 is sequentially exhausted to the outside of the vacuum chamber through the atmospheric pressure (the exhaust groove 54), the low vacuum (the exhaust groove 56), and the medium vacuum (the exhaust groove 58). Therefore, the leakage of the levitation gas in the air pads 36, 38, and 40 into the vacuum chamber is effectively prevented.

As described above, the stage device 1 according to the present embodiment can be used in a vacuum environment such as inside the vacuum chamber. Here, the vacuum represents a state of a space filled with a gas having a pressure lower than a normal atmospheric pressure. The vacuum is classified into a low vacuum (100 kPa to 100 Pa), a medium vacuum (100 Pa to 0.1 Pa), a high vacuum (0.1 Pa to 10⁻⁵ Pa), an ultra-high vacuum (10⁻⁵ Pa or lower), and the like depending on a pressure region. The stage device 1 according to the present embodiment may be used in a vacuum environment of any of the above categories, or may be used in a non-vacuum environment. The stage device 1 according to the present embodiment is particularly suitable for use in a low-pressure vacuum environment where high cleanliness is required.

In FIG. 5, the air pads 36, 38, and 40 constituting the second gas levitation portion that levitates the Y slider 150, which is a part of the first drive shaft 100, from the Y guide 210, which is a main body of the second drive shaft 200, by gas are illustrated, but similarly, air pads constituting a first gas levitation portion that levitates the X slider 21, which is a part of the driven body, from the X guide 110, which is a main body of the first drive shaft 100, by gas may be provided.

For example, as illustrated in FIG. 1, an air pad group similar to the air pads 36, 38, and 40 is preferably provided between the inner peripheral surface of the X guide 110 having a box shape and the outer peripheral surface of the X slider 21 having a rectangular parallelepiped shape accommodated inside the X guide 110. Further, an exhaust groove group for differential exhaust similar to the exhaust grooves 54, 56, and 58 is preferably formed on the outer peripheral surface of the X slider 21 so as to surround the air pad group. By such a plurality of exhaust grooves, the levitation gas (the first levitation gas) in the air pads is sequentially exhausted to the outside of the vacuum chamber through the atmospheric pressure, the low vacuum, and the medium vacuum. Therefore, the leakage of the levitation gas in the air pads into the vacuum chamber is effectively prevented.

According to the present embodiment as described above, high responsiveness during driving can be achieved by the first drive shaft 100 and the second drive shaft 200 that drive the driven body such as the X slider 21 and the first drive shaft 100 by magnetism (the first linear motor 120 and the second linear motor 220), and high smoothness during driving can be achieved by the first gas levitation portion and the second gas levitation portion that levitate the driven body such as the X slider 21 and the first drive shaft 100 by gas. Since the first gas levitation portion and the second gas levitation portion include an exhaust mechanism for the levitation gas, the stage device 1 according to the present embodiment can be used in a vacuum environment such as inside the vacuum chamber.

The present disclosure has been described above based on the embodiments. Various modifications are possible for combinations of the components and processes in the illustrative embodiments, and it will be apparent to those skilled in the art that such modifications are included within the scope of the present disclosure.

The configurations, operations, and functions of the respective devices and methods described in the embodiments can be implemented by hardware resources or software resources, or by cooperation of hardware resources and software resources. As hardware resources, for example, a processor, ROM, RAM, and various integrated circuits can be used. As software resources, for example, programs such as an operating system and an application can be used.

### Industrial Applicability

The present disclosure relates to a driving device and the like.

### Reference Signs List

1: stage device
2: stage
21: X slider
100: first drive shaft
110: X guide
120: first linear motor
130: first coil portion
140: first magnet portion
144: first magnetic shielding portion
145: second magnetic shielding portion
150: Y slider
200: second drive shaft
210: Y guide
220: second linear motor
230: second coil portion
240: second magnet portion

## Claims

1. A driving device comprising:
a first drive shaft that drives a driven body in a first direction by magnetism;
a second drive shaft that drives the driven body and the first drive shaft integrally in a second direction intersecting the first direction by magnetism and that supports the first drive shaft from below in a third direction intersecting the first direction and the second direction;
a first gas levitation portion that levitates the driven body from the first drive shaft by gas; and
a second gas levitation portion that levitates the first drive shaft from the second drive shaft by gas.

2. The driving device according to claim 1,
wherein a first linear motor that drives the driven body along the first drive shaft is constituted by the driven body and the first drive shaft, and
a second linear motor that drives the first drive shaft along the second drive shaft is constituted by the first drive shaft and the second drive shaft.

3. The driving device according to claim 2,
wherein the driven body includes a placement portion having a surface on which an object is placed, and a first slider that is connected to the placement portion on a rear surface side, and
the first linear motor is provided between the placement portion and the first slider.

4. The driving device according to claim 3,
wherein in the first linear motor, a first coil portion through which a current flows is provided on the first drive shaft so as to protrude toward the second direction, and a first magnet portion that interacts with a magnetic field generated by the first coil portion is provided on the first slider so as to cover the first coil portion from the second direction.

5. The driving device according to claim 4,
wherein a length of the first coil portion in the first direction is longer than a length of the first magnet portion in the first direction.

6. The driving device according to claim 5,
wherein the first magnet portion includes a magnetic shielding portion that magnetically shields at least an edge portion of an opening into which the first coil portion is inserted.

7. The driving device according to claim 5,
wherein the first magnet portion includes a magnetic shielding portion that magnetically shields at least a surface side on which the placement portion is provided.

8. The driving device according to claim 5,
wherein a magnetic shielding portion that shields magnetism is provided between the placement portion and the first magnet portion.

9. The driving device according to any one of claims 3 to 8,
wherein the first drive shaft includes a first guide that guides driving of the first slider in the first direction, and a second slider that is connected to the first guide on a lower side of the first guide, and
the second linear motor is provided between the first guide and the second slider.

10. The driving device according to claim 9,
wherein in the second linear motor, a second coil portion through which a current flows is provided on the second drive shaft so as to protrude toward the first direction, and a second magnet portion that interacts with a magnetic field generated by the second coil portion is provided on the second slider so as to cover the second coil portion from the first direction.

11. The driving device according to claim 10,
wherein a length of the second coil portion in the second direction is longer than a length of the second magnet portion in the second direction.

12. The driving device according to claim 11,
wherein the second coil portion is provided at a position spaced apart from a main body of the second drive shaft in the first direction.

13. The driving device according to any one of claims 1 to 8,
wherein the driving device is used in a vacuum environment.

14. A positioning device that positions the driven body using the driving device according to any one of claims 1 to 8.

15. A processing device that performs predetermined processing on the driven body positioned by the positioning device according to claim 14.

16. A device manufacturing method comprising:
manufacturing a device through the processing performed by the processing device according to claim 15.
